# EUROPEAN PATENT SPECIFICATION

(11) **EP 2 481 082 B1**
(45) Date of publication and mention of the grant of the patent: **21.06.2017**
(21) Application number: 10819542.1
(22) Date of filing: 24.09.2010
(51) Int. Cl.: H01L 21/22, H01L 21/205, C30B 25/14, C23C 16/455, H01L 21/67

(54) **HYBRID GAS INJECTOR**
HYBRIDGASINJEKTOR
INJECTEUR DE GAZ HYBRIDE

(30) Priority: 25.09.2009 US 277361 P
(43) Date of publication of application: 01.08.2012
(73) Proprietor: Ferrotec (USA) Corporation, Bedford, NH 03110 (US)
(72) Inventor: O'MOORE, Fergal, Los Gatos, California 95030 (US); WILLIAMS, Karl, Scotts Valley, California 95066 (US); LE, Nam, Milpitas California 95035 (US); BROWN, Vincent, Mountain View California 94040 (US)
(74) Representative: Katérle, Axel
(86) International application number: PCT/US2010/050217
(87) International publication number: WO 2011/038242

(56) References cited:
- WO-A1-2006/030857
- JP-A- 10 284 426
- JP-A- 2001 230 212
- JP-A- 2001 351 871
- JP-A- 2002 118 066
- US-A1- 2006 185 589
- US-A1- 2006 211 218

## Description

### BACKGROUND OF THE INVENTION

### 1. Field of the Invention

The invention relates generally to thermal processing of semiconductor wafers. In particular, the invention relates to gas injectors in a thermal treatment furnace.

### 2. Description of the Prior Art

Batch thermal processing continues to be used for several stages in the fabrication of silicon integrated circuits. One low temperature thermal process deposits a layer of silicon nitride by chemical vapor deposition, typically using chlorosilane and ammonia as the precursor gases at temperatures in the range of about 700ºC. Other low-temperature processes include the deposition of polysilicon or silicon dioxide or other processes utilizing lower temperatures. High-temperature processes include oxidation, annealing, silicidation, and other processes typically using higher temperatures, for example above 1000ºC or even 1200ºC.

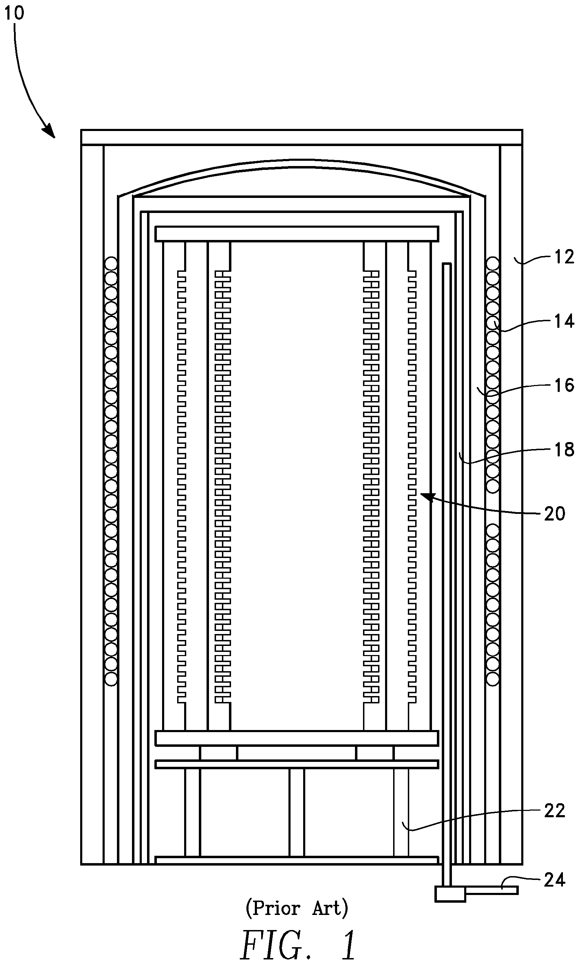

Large-scale commercial production typically uses vertical furnaces and vertically arranged wafer towers supporting a large number of wafers in the furnace, often in a configuration illustrated in the schematic cross-sectional view of FIG. 1. The furnace includes a thermally insulating heater canister 12 supporting a resistive heating coil 14 powered by an unillustrated electrical power supply. A bell jar 16, typically composed of quartz, includes a roof and fits within the heating coil 14. An open-ended liner 18 may be used, which fits within the bell jar 16. A support tower 20 sits on a pedestal 22 and, during processing, the pedestal 22 and support tower 20 are generally surrounded by the liner 18. The tower 20 includes vertically arranged slots for holding multiple horizontally disposed wafers to be thermally processed in batch mode. A gas injector 24 principally disposed between the tower 20 and the liner 18 has an outlet on its upper end for injecting processing gas within the liner 18. Typically, multiple gas injectors 24 of different lengths inject the processing gas at multiple heights. An unillustrated vacuum pump removes the processing gas through the bottom of the bell jar 16. The heater canister 12, bell jar 16, and liner 18 may be raised vertically to allow wafers to be transferred to and from the tower 20, although in some configurations these elements remain stationary while an elevator raises and lowers the pedestal 22 and loaded tower 20 into and out of the bottom of furnace 10.

The bell jar 18, closed on its upper end, causes the furnace 10 to tend to have a generally uniformly hot temperature in the middle and upper portions of the furnace. This is referred to as the hot zone in which the temperature is controlled for the optimized thermal process. However, the open bottom end of the bell jar 18 and the mechanical support of the pedestal 22 cause the lower end of the furnace to have a lower temperature, often low enough that the process such as chemical vapor deposition is not completely effective. The hot zone may exclude some of the lower slots of the tower 20.

Conventionally in low-temperature applications, the tower, liner, and injectors have been composed of quartz or fused silica. However, quartz towers and injectors are being supplanted by silicon towers and injectors. One configuration of a silicon tower available from Integrated Materials, Inc. of Sunnyvale, California is described by Boyle et al. in U.S. patent 6,455,395, incorporated herein by reference. Silicon liners have been proposed by Boyle et al. in U.S. published patent application 2002/0170486.

Zehavi et al. disclose a silicon injector 24, illustrated in the orthographic view of FIG. 2, and its fabrication method in U.S. published patent application 2006/0185589. It includes an injector straw 26 (also referred to as a tube) and a connector 28 (also known as a knuckle). The connector 28 includes a supply tube 20 and an elbow 32 having a recess to receive the injector straw 26. The supply tube 30 may have an outer diameter of approximately 4 to 8mm with a correspondingly sized inner circular bore 34. The supply tube 30 passes through the lower manifold of the furnace.

The end of the supply tube 30 may be connected through a vacuum fitting and O-ring such an Ultratorr fitting, to a gas supply line supplying the desired gas or gas mixture into the furnace (e.g., ammonia and silane for the CVD deposition of silicon nitride). The entire integral connector 28 may be machined from annealed virgin polysilicon according to the process described by Boyle et al. in U.S. Patent 6,450,346. The machining includes connecting the supply bore 34 to the recess receiving the straw. Alternatively, the connector 28 may assembled from a separate tube 30 fit into and bonded to the separately machined elbow 32.

The injector straw 26 is formed with a injector bore 36, for example, a circular bore having a diameter similar to that of the circular bore 34 of the supply tube 30 extending along its entire length. The injector straw 24 may have a beveled end, as illustrated, for example facing the chamber liner or it may have a flat end perpendicular to the axis of the straw 26. The cross-sectional shape of the injector straw 26 may be substantially square, as illustrated, or may be octagonal or round or be otherwise shaped depending upon the requirements of the furnace maker and the fab line. The injector straw 42 may be composed of two shells 54, 56, which are joined together through unillustrated tongue-and- groove structure extending axially along straw.

All the parts of the injector 40 of Zehavi et al. are composed of silicon, preferably polysilicon and most preferably virgin polysilicon. The parts may be fused together using a curable adhesive composed of spin-on glass (SOG) and silicon powder, as described by Boyle et al. in U.S. patent 7,083,694. The flowable adhesive is applied to the joint area of the parts, which are then assembled into the illustrated structure. The structure is then annealed at a temperature in the range of 900 to 1100°C to convert the spin-on glass to a silica matrix tightly bonded to the silicon parts and incorporating the silicon powder.

The silicon gas injector has been very effective at reducing the number of particles generated in the furnace, which deleteriously fall on the processed wafers and reduce the yield.

From JP 2001 230212 A a semiconductor heat treatment equipment for a furnace is known comprising a gas introducing pipe for introducing process gases into the treatment zone of the furnace. In order to prevent condensation of process gases the gas introducing pipe is made of quartz.

### SUMMARY OF THE INVENTION

Unfortunately there are deficiencies to the above described conventional unitary silicon gas injector. Fabricating the complex silicon injector is a tedious and expensive process. As a result, the silicon injector is expensive even though the expense is mitigated by the increased production yield and extended injector lifetime. Also, the silicon structure is long, sometimes well over a meter in length, fragile, and subject to breakage. Shipping the assembled injector requires care to prevent the injector being broken in transit. Whenever the long straw breaks, the injector obviously needs to be replaced with a new injector. Also, when the injector reaches its end of life due primarily to build up of the deposition product such that wafer defects increase or the deposition rate or uniformity changes, the injector is typically thrown away and replaced with an expensive new one.

Although the all-silicon gas injector has provided improved performance over previously used structures in terms of reducing unwanted particle generation, this improved performance is only necessary for portions of the injector exposed to very high temperatures. Indeed, only the straw of the injector extends into the process region of the hot zone and is subject to extensive coating by the process gas. The connector or knuckle is below the process region and experiences a lower temperature so that it does not experience significant deposition.

In contrast to the above described conventional gas injectors, an improved gas injector according to claim 1 includes a hybrid construction having (i) a straw made of a high-purity material such as silicon that is constructed and arranged to extend through the hot zone of the furnace while resisting particle formation and (ii) a connector made of another material that is less fragile, cheaper to manufacture and is constructed and arranged to be disposed outside of the hot zone capable of producing unwanted particle formation (generally delimited by the heating coils 14 of the furnace). The straw may alternatively be made of silicon carbide. An example connector may be made of stainless steel or Inconel.

The material of the connector is preferably more robust than the material of the straw and preferably of lower cost. For silicon straws, quartz and silicon carbide can be used for the connector. However, a strong metal such as stainless steel or Inconel is preferred for the connector because of its superior strength and ease of machining. Additionally, stainless steel and Inconel do not affect the purity levels of the gas to be pumped.

Advantageously, the straw is joined to the connector through a detachable coupling, for example, using threaded elements such as screws. As a result, the straw and connector can be separately shipped as less complex structures and easily assembled on site. Also, replacement of the straw does not require a new connector. If the straw breaks or becomes excessively coated, a new straw can be joined to the previously used connector. The connector, as mentioned previously, is subject to much less deposition. If it needs to be cleaned, its smaller size, reduced complexity, and robust composition facilitate cleaning.

For example, one embodiment is directed to a gas injector for injecting processing gas into a hot zone of a vertical furnace between a tower supporting multiple wafers and a tubular liner. The gas injector includes a tubular straw defining a first bore extending along a first axis of the tubular straw from a first distal end to a first proximate end. The tubular straw is made of a first material selected from at least one of silicon, quartz, and silicon carbide. The gas injector also includes a connector detachably connected to and in fluid communication with the tubular straw. The connector is made of a second material being different than the first material and a supply tube defining a second bore extending along a second axis of the supply tube. The second axis is substantially perpendicular to the first axis. The connector is constructed and arranged to (i) receive the processing gas from a gas supply line at a second distal end of the supply tube, and (ii) deliver the processing gas to the first proximate end of the tubular straw at a second proximate end of the supply tube.

### BRIEF DESCRIPTION OF THE DRAWINGS

FIG. 1 is a cross-sectional view of a vertical furnace.
FIG. 2 is an orthographic view of an all silicon gas injector.
FIG. 3 is an orthographic view of a first embodiment of a gas injector of the present invention.
FIG. 4 is an orthographic view of a second embodiment of a gas injector of the present invention.

### DETAILED DESCRIPTION OF THE PREFERRED EMBODIMENT

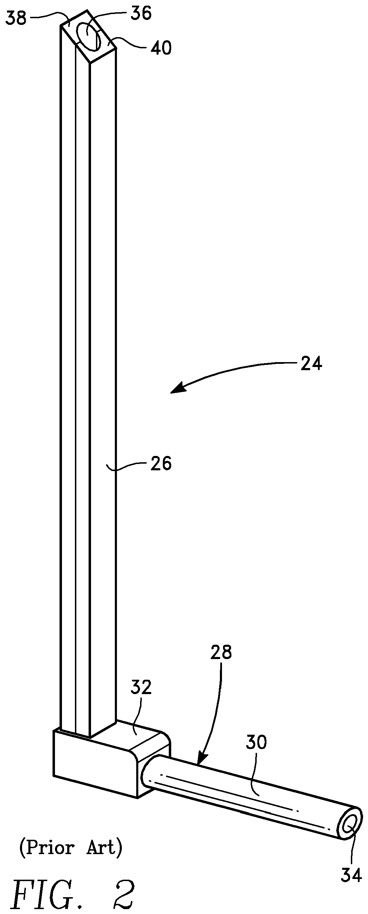

The preferred embodiment(s) of the present invention is illustrated in Figs. 1-4.

An improved gas injector includes a hybrid construction having (i) a straw made of a high-purity material (e.g., silicon, quartz or silicon carbide) that is constructed and arranged to extend through the hot zone of the furnace while resisting particle formation and (ii) a connector made of another material (e.g., stainless steel or Inconel) that is less fragile, cheaper to manufacture and is constructed and arranged to be disposed outside of the hot zone capable of producing unwanted particle formation.

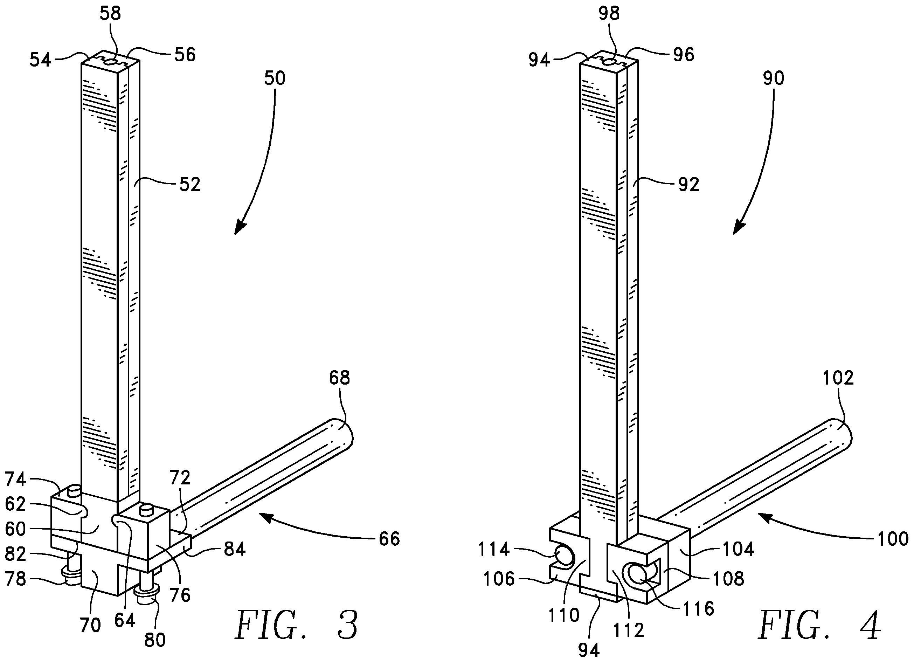

One embodiment of a hybrid gas injector 50, illustrated in the orthographic view of FIG. 3, includes a silicon straw 52, formed of two polysilicon shells 54, 56 fused together and having a first bore 58 formed between them. The lower end of the straw 52 is bonded to an adaptor 60 also having a central bore extending through it and aligned with the first bore 58 of the straw 52. Two notches 62, 64 are machined into the adaptor 60 to extend along two opposed sides perpendicularly to the axis of the straw 52. The adaptor 60 may be formed of polysilicon, which can be easily machined in the small size required. The adaptor 60 is relatively small and simply shaped and can be machined from a single member. The machined adaptor 60 can be fused to the polysilicon shells 54, 56 in the same SOG/silicon fusing operation which form the major portion of the straw 52 or be fused in a separate operation.

A connector 66 is composed of a metal, preferably stainless steel or Inconel and includes a supply tube 68 with its central bore for connection to the gas supply line. The supply tube 66 is joined, for example, by welding to a stainless steel elbow 70 having two connecting and perpendicularly arranged vertical and horizontal bores machined into it to connect between the first bore 58 of the straw 52 and that of the supply tube 68. The elbow 70 has a flat upper surface 72 on which the adapter 60 rests with its central bore in alignment with the vertical bore within the elbow 70. Two clamps 74, 76 have respective horizontally extending teeth which can engage the notches 62, 64 of the adaptor 60. Screws 78, 80 freely pass through flanges 82, 84 of the adaptor 70 and are threaded into the clamps 74, 76. Thereby, the screws 78, 80 can tighten the adaptor 60 against the flat surface 72 of the elbow 70 surrounding the vertical elbow bore. The screws 78, 80 can be untightened to release the connector 66 from the straw 52. Thereby, if the straw 52 needs to be replaced because of breakage or age, the connector 66 can be reused for a new straw 52. Preferably the holders 74, 76 and the screws 78, 80 are also composed of stainless steel.

The seals between the parts do not have to provide a high-pressure seal. Silicon seems to adequately seal to a metal. However, it is contemplated that a sealing material may be advantageously used, such as a metal seal like a c-seal or a high-temperature elastomeric seal such as Kalrez. The seal needs to accommodate differential thermal expansion between the parts of differing material while maintaining the proximity of the parts for gaseous sealing.

Another embodiment of a hybrid gas injector 90, illustrated in the orthographic view of FIG. 4, includes a straw 92, similar to that of FIG. 3, which includes first and second shells 94, 96 with a first bore 98 formed axially along them. However, the second shell 96 includes an unillustrated side aperture near but offset from its lower end. Also, an end plate 94 is bonded and sealed to the bottom of the shells 94, 96 to block the first bore 98. The shells 94, 96 and end plate 94 are formed of the same material, for example, quartz, silicon carbide, or silicon, but preferably of polysilicon, and most preferably virgin polysilicon. The silicon end plate 94 can be fused to the shells 94, 96 at the same time they are fused together.

An adaptor 100 includes a supply tube 102 joined to a base 104 of a clamping structure, for example, by welding. The base 104 includes an unillustrated aperture in communication with the central bore of the supply tube and aligned with the side aperture in the second shell 96. Two removable clamps 106, 108 include ears 110, 112 which can abut the first shell 94 opposite the aperture in the second shell 96. The corners of the first shell 94 may be rounded to conform to the concave inner surface of the ears 110, 112. Screws 114, 116 pass through holes in the clamps are threaded into the base 104. Thereby, the screws 114, 116 can tighten the ears 110, 112 against the first shell 94 to hold the bottom of the straw 92 to the adaptor 100 and to seal the aperture in the second shell 96 to the bore of the base 104 to provide fluid communication between the central bore 98 of the straw 92 to the bore of the supply tube 102. If the screws 114, 116 are untightened, the straw 92 may be detached from the connector 100.

The invention provides many advantages. The part of the injector exposed to high temperature, that is, the straw, has a simple shape allowing it to be more easily formed of critical materials such as silicon. The rest of the injector can be more easily formed of noncritical materials, especially of stainless steel, which can be more easily formed into the required shape. The connector and especially the required 90º bend can be formed of more rugged materials. Simpler parts can be shipped and easily assembled on site. If a straw needs to be replaced, the connector can be attached to a new straw without being disconnected from its gas line, thereby reducing maintenance cost. The simpler design of the straw facilitates cleaning of the straw rather than discarding the entire complex and difficult to clean unitary injector. Overall cost of consumables and cost of ownership is reduced because of the reusable connector made of less expensive materials.

Although the preferred embodiments of the present invention have been described herein, the above description is merely illustrative. Further modification of the invention herein disclosed will occur to those skilled in the respective arts and all such modifications are deemed to be within the scope of the invention as defined by the appended claims.

## Claims

1. A gas injector (50, 90) for injecting processing gas into a hot zone of a vertical furnace (10) between a tower (20) supporting multiple wafers and a tubular liner (18), the gas injector (50, 90) comprising:
a tubular straw (52, 92) defining a first bore (58, 98) extending along a first axis of the tubular straw (52, 92) from a first distal end to a first proximate end, the tubular straw (52, 92) made of a first material selected from the group consisting of silicon and silicon carbide; and
a connector (70, 104) detachably connected to and in fluid communication with the first bore (58, 98) of the tubular straw (52, 92), the connector (70, 104) made of a second material being different than the first material, the connector including a supply tube (66, 100) defining a second bore extending along a second axis of the supply tube, the second axis being substantially perpendicular to the first axis, the connector (70, 104) being constructed and arranged to (i) receive the processing gas from a gas supply line at a second distal end of the supply tube (66, 100), and (ii) deliver the processing gas to the tubular straw (52, 92) from the supply tube (66, 100);
**characterized by**:
at least one clamp (74, 76, 106, 108); and
a screw (78, 80, 114, 116) threaded through each of the at least one clamp (74, 76, 106, 108) and into the connector (70, 104), wherein the screw (78, 80, 114, 116) is configured to be tightened to hold each clamp (74, 76, 106, 108) against the tubular straw (52, 92), thereby holding the tubular straw (52, 92) in fluid communication with the supply tube (66, 100).

2. The gas injector (50, 90) of claim 1, wherein the second material is a metal.

3. The gas injector (50, 90) of claim 2, wherein the metal is stainless steel.

4. The gas injector (50, 90) of claim 1, wherein the first material is polysilicon.

5. The gas injector (50, 90) of claim 4, wherein the second material is stainless steel.

6. The gas injector (50) of claim 1, wherein the tubular straw (52) further comprises an adapter (60) fused to the first proximate end of the tubular straw (52), the adapter (60) having a central bore extending therethrough and aligned with the first bore (58) of the tubular straw (52, 92), and the adapter (60) having notches (62, 64) extending along opposed sides of the adapter (60) and substantially perpendicular to the central bore (58) of the tubular straw (52, 92).

7. The gas injector (90) of claim 1, wherein the tubular straw (92) defines a side aperture offset from the first proximate end, and wherein the tubular straw (92) further comprises an end plate (94) fused to the first proximate end of the tubular straw (92) and blocking the first bore of the tubular straw (92) at the first proximate end, wherein the end plate (94) is made of the first material.

## Patentansprüche

1. Gasinjektor (50, 90) zum Einlassen von Prozessgas in einen heißen Bereich eines Vertikalofens (10) zwischen einem Turm (20), der mehrere Wafer trägt, und einem röhrenförmigen Mantel (18), wobei der Gasinjektor (50, 90) umfasst:
einen röhrenförmiger Schaft (52, 92), der eine erste Bohrung (58, 98) bestimmt, die sich entlang einer ersten Achse des röhrenförmigen Schafts (52, 92) von einem ersten entfernten Ende zu einem ersten nächsten Ende erstreckt, wobei der röhrenförmige Schaft (52, 92) aus einem ersten Material hergestellt ist, das aus der Gruppe bestehend aus Silizium und Siliziumkarbid ausgewählt ist; und
einen Verbinder (70, 104), der lösbar mit der ersten Bohrung (58, 98) des röhrenförmigen Schafts (52, 92) verbunden ist und mit dieser in fluidischer Verbindung steht, wobei der Verbinder (70, 104) aus einem zweiten, vom erstem Material unterschiedlichen Material hergestellt ist, wobei der Verbinder (70, 104) ein Zufuhrrohr (66, 100) enthält, das eine zweite Bohrung bestimmt, die sich entlang einer zweiten Achse des Zufuhrrohrs erstreckt, wobei die zweite Achse im Wesentlichen senkrecht zu der ersten Achse ist, wobei der Verbinder (70, 104) ausgebildet und angeordnet ist, um (i) das Prozessgas von einer Gaszuführleitung an einem zweiten entfernten Ende des Zufuhrrohrs (66, 100) aufzunehmen, und (ii) das Prozessgas von dem Zufuhrrohr (66, 100) an den röhrenförmigen Schaft (52, 92) weiterzuleiten;
**gekennzeichnet durch**
wenigstens eine Klemme (74, 76, 106, 108); und
eine Schraube (78, 80, 114, 116), die durch jede der wenigstens einen Klemme (74, 76, 106, 108) und in den Verbinder (70, 104) eingedreht ist, wobei die Schraube (78, 80, 114, 116) dazu ausgebildet ist, festgezogen zu werden, um jede Klemme (74, 76, 106, 108) gegen den röhrenförmigen Schaft (52, 92) zu halten, und dadurch den röhrenförmigen Schaft (52, 92) in fluidischer Verbindung mit dem Zufuhrrohr (66, 100) zu halten.

2. Gasinjektor (50, 90) nach Anspruch 1, wobei das zweite Material ein Metall ist.

3. Gasinjektor (50, 90) nach Anspruch 2, wobei das Metall korrosionsbeständiger Stahl ist.

4. Gasinjektor (50, 90) nach Anspruch 1, wobei das erste Material Polysilizium ist.

5. Gasinjektor (50, 90) nach Anspruch 4, wobei das zweite Material korrosionsbeständiger Stahl ist.

6. Gasinjektor (50) nach Anspruch 1, wobei der röhrenförmige Schaft (52) ferner einen Adapter (60) aufweist, der an das erste nächste Ende des röhrenförmigen Schafts (52) geschmolzen ist, wobei der Adapter (60) eine zentrale Bohrung hat, die sich durch diesen erstreckt und mit der ersten Bohrung (58) des röhrenförmigen Schafts (52, 92) fluchtet, und wobei der Adapter (60) Einkerbungen (62, 64) hat, die entlang entgegengesetzter Seiten des Adapters (60) verlaufen und im Wesentlichen senkrecht zu der zentralen Bohrung (58) des röhrenförmigen Schafts (52, 92) sind.

7. Gasinjektor (90) nach Anspruch 1, wobei der röhrenförmige Schaft (92) eine seitliche Öffnung bestimmt, die versetzt bezüglich des ersten nächsten Endes ist, und wobei der röhrenförmige Schaft (92) ferner eine Endplatte (94) aufweist, die an das erste nächste Ende des röhrenförmigen Schafts (92) geschmolzen ist und die erste Bohrung des röhrenförmigen Schafts (92) an dem ersten nächsten Ende verschließt, wobei die Endplatte (94) aus dem ersten Material hergestellt ist.

## Revendications

1. Injecteur (50, 90) de gaz pour injecter un gaz de traitement dans une zone chaude d'un four vertical (10) entre une tour (20) supportant des plaquettes multiples et une enveloppe intérieure tubulaire (18), l'injecteur (50, 90) de gaz comprenant :
une colonne tubulaire (52, 92) définissant un premier alésage (58, 98) s'étendant le long d'un premier axe de la colonne tubulaire (52, 92) d'une première extrémité distale à une première extrémité proximale, la colonne tubulaire (52, 92) constituée d'un premier matériau choisi parmi le groupe consistant en le silicium et le carbure de silicium ; et
un connecteur (70, 104) connecté de manière détachable au et en communication de fluide avec le premier alésage (58, 98) de la colonne tubulaire (52, 92), le connecteur (70, 104) constitué d'un deuxième matériau étant différent du premier matériau, le connecteur incluant un tube (66, 100) d'alimentation définissant un deuxième alésage s'étendant le long d'un deuxième axe du tube d'alimentation, le deuxième axe étant sensiblement perpendiculaire au premier axe, le connecteur (70, 104) étant construit et agencé pour (i) recevoir le gaz de traitement provenant d'une ligne d'alimentation en gaz à une deuxième extrémité distale du tube (66, 100) d'alimentation, et (ii) délivrer le gaz de traitement jusqu'à la colonne tubulaire (52, 92) depuis le tube (66, 100) d'alimentation ;
**caractérisé par**
au moins une bride de serrage (74, 76, 106, 108) ; et
une vis (78, 80, 114, 116) filetée à l'intérieur de chacune de l'au moins une bride de serrage (74, 76, 106, 108) et dans le connecteur (70, 104), dans lequel la vis (78, 80, 114, 116) est configurée pour être serrée pour maintenir chaque bride de serrage (74, 76, 106, 108) contre la colonne tubulaire (52, 92), maintenant ainsi la colonne tubulaire (52, 92) en communication de fluide avec le tube (66, 100) d'alimentation.

2. Injecteur (50, 90) de gaz selon la revendication 1, dans lequel le deuxième matériau est un métal.

3. Injecteur (50, 90) de gaz selon la revendication 2, dans lequel le métal est un acier inoxydable.

4. Injecteur (50, 90) de gaz selon la revendication 1, dans lequel le premier matériau est un polysilicium.

5. Injecteur (50, 90) de gaz selon la revendication 4, dans lequel le deuxième matériau est un acier inoxydable.

6. Injecteur (50) de gaz selon la revendication 1, dans lequel la colonne tubulaire (52) comprend en outre un adaptateur (60) fusionné avec la première extrémité proximale de la colonne tubulaire (52), l'adaptateur (60) ayant un alésage central s'étendant à travers celle-ci et aligné avec l'alésage central (58) de la colonne tubulaire (52, 92), et l'adaptateur (60) ayant des entailles (62, 64) s'étendant le long de côtés opposés de l'adaptateur (60) et sensiblement perpendiculaires à l'alésage central (58) de la colonne tubulaire (52, 92).

7. Injecteur (90) de gaz selon la revendication 1, dans lequel la colonne tubulaire (92) définit une ouverture latérale décalée par rapport à la première extrémité proximale, et dans lequel la colonne tubulaire (92) comprend en outre une plaque (94) d'extrémité fusionnée avec la première extrémité proximale de la colonne tubulaire (92) et bloquant le premier alésage de la colonne tubulaire (92) à la première extrémité proximale, dans lequel la plaque (94) d'extrémité est constituée du premier matériau.
